# EUROPEAN PATENT SPECIFICATION

(11) **EP 2 652 800 B1**
(45) Date of publication and mention of the grant of the patent: **22.07.2015**
(21) Application number: 11813471.7
(22) Date of filing: 12.12.2011
(51) Int. Cl.: H01L 31/048, H01L 31/18

(54) **RESTRIPPABLE PHOTOVOLTAIC COATINGS**
WIEDERABLÖSBARE FOTOVOLTAISCHE BESCHICHTUNGEN
REVÊTEMENTS PHOTOVOLTAÏQUES PELABLES PLUSIEURS FOIS

(30) Priority: 17.12.2010 US 201061424510 P
(43) Date of publication of application: 23.10.2013
(73) Proprietor: Rohm and Haas Company, Philadelphia, PA 19106 (US)
(72) Inventor: TYSAK, Theodore, Ambler, PA 19002 (US); NUNGESSER, Edwin, Horsham, PA 19044 (US); GREER, Edward, Lower Gwynedd, PA 19002 (US)
(74) Representative: Houghton, Mark Phillip
(86) International application number: PCT/US2011/064422
(87) International publication number: WO 2012/082622

(56) References cited:
- EP-A1- 1 227 116
- WO-A1-2009/133827
- WO-A1-2009/157449
- US-A1- 2008 128 018
- US-A1- 2009 159 118
- US-A1- 2010 000 603

## Description

### Field

The present invention relates to coatings which are particularly useful with photovoltaic modules, and more particularly, to restrippable coatings for photovoltaic modules.

### Background

Permanent coatings to reduce the refractive index difference between the exterior sun-facing layer of a photovoltaic module and its environment are generally known. However, in operation, permanent coatings have certain drawbacks. First, the coating must remain intact without clouding or yellowing for the lifetime of the device, which is usually on the order of multiple years. Second, all photovoltaic modules eventually attract dust, soil films, and other environment detritus incident with being outside. Accordingly, the photovoltaic module must be cleaned. As can be appreciated by those skilled in the art, the relatively low efficiency of photovoltaic modules means that any clouding from, or failure to clean the photovoltaic module back to, its original state results in a material loss of efficiency.

Therefore, what is needed are coatings that offer easier cleaning, and optionally, antireflective properties.

### Detailed Description

Applicants have advantageously solved the foregoing needs by discovering coatings suitable for the exterior sun-facing layer of a photovoltaic module, said coatings being able to be removed and reapplied, i.e., they are restrippable. Optionally, the coatings can reduce the refractive index difference between the photovoltaic module and its environment. Optionally, the coatings are self stripping.

The present invention provides methods as described in claims 1-10. In other words, the present invention provides a restrippable coating for photovoltaic modules.

A "photovoltaic module" is any electronic device that converts light to energy. In one embodiment, the photovoltaic module has an exterior surface area of at least 0.093 m² (1.0 ft²), preferably at least 0.46 m² (5.0 ft²), more preferably at least 0.93 m² (10 ft²), it being understood that the upper limit is bound by the fabrication standards of photovoltaic modules. In one embodiment, the photovoltaic module is a solar panel of a sufficient size to generate at least 100 peak watts under standard solar illumination.

The restrippable coating is a clear aqueous acrylic composition, containing a highly hydrophilic addition copolymer, a water miscible organic coalescing agent or plasticizer and, as optional components, a polyvalent metal compound, a rheology modifier, an alkali-soluble resin and a wax, with or without a wax-soluble resin, and optionally a silane coupling agent; also optionally a material which reduces reflection.

Such compositions, when formulated with desirable additives such as wetting agents and leveling agents, and adjusted to a final alkaline pH of between 7.0 to about 10 or more, after application to a substrate, dry to form clear to diffuse coatings. Moreover, removal of these coatings using alkaline or detergent solutions is effected easily.

Optionally, compositions of the present invention contain anti-reflective compositions, such as a 0.5-20µm particle, crosslinked or uncrosslinked, single or multiple stage, graded refractive index or single refractive index which are capable of reducing the gloss such as disclosed in US7829626, US7768602, US4403003. Document US2008/128018A describes coating for solar modules.

In one embodiment, acrylic compositions are based on polymers having an average molecular weight (5,000 < Mw < 10,000,000), moderately acid functionalized (meth)acrylate or styrene/methacrylate copolymer emulsions that are optimized to provide clear films, soil resistance, and very easy removability, with sufficient durability to withstand the damage of weathering. As used herein the term "(meth)acrylic" refers to acrylic or methacrylic, and "(meth)acrylate" refers to acrylate or methacrylate. The term "(meth)acrylamide" refers to acrylamide (AM) or methacrylamide (MAM). "Acrylic monomers" include acrylic acid (AA), methacrylic acid (MAA), esters of AA and MAA, itaconic acid (IA), crotonic acid (CA), acrylamide (AM), methacrylamide (MAM), and derivatives of AM and MAM, e.g., alkyl (meth)acrylamides. Esters of AA and MAA include, but are not limited to, alkyl, hydroxyalkyl, phosphoalkyl and sulfoalkyl esters, e.g., methyl methacrylate (MMA), ethyl methacrylate (EMA), butyl methacrylate (BMA), hydroxyethyl methacrylate (HEMA), hydroxyethyl acrylate (HEA), hydroxypropyl methacrylate (HPMA), hydroxybutyl acrylate (HBA), methyl acrylate (MA), ethyl acrylate (EA), butyl acrylate (BA), 2-ethylhexyl acrylate (EHA), cyclohexyl methacrylate (CHMA), benzyl acrylate (BzA) and phosphoalkyl methacrylates (e.g., PEM). The polymer compositions of this invention may contain crosslinking agents, such as crosslinking monomers. These are multi-functional monomers which are capable of forming covalent, or otherwise permanent crosslinks of the polymer molecules in the reaction processes which form the polymers, or they are capable of reacting in or on the preformed polymer emulsion to form crosslinks before the polymeric film is formed. Examples of the useful covalent crosslinking monomers include allyl acrylate, allyl methacrylate, butylene glycol dimethacrylate, diallyl maleate, diallyl phthalate, divinyl benzene, hexan-1,6-diol diacrylate, acetylacetoxyethyl methacrylate, methylol methacrylamide, trimethylolpropanetriacrylate, trimethylolpropanetrimethacrylate. This listing is illustrative and other reagents, crosslinking monomers, and crosslinking reaction schemes to produce intermolecular crosslinking in emulsion polymers before film formation will be evident to be within this invention.

"Styrenic monomers" include styrene, α-methylstyrene; 2-, 3-, or 4-alkylstyrenes, including methyl- and ethyl-styrenes.

In one embodiment, the acid functionality may be reacted with Zinc (ZnO or Zinc ammonium bicarbonate) to crosslink the film and provide additional durability and removability. As can be appreciated, acid functionality in the polymer backbone provides improved particle size control, emulsion stability, higher hydrophilic character to the film (for improved resistance properties), and increased film sensitivity to the alkaline solutions used to remove the coating film. Acid functionality in the polymer backbone also results in poor resistance to the alkaline solutions used to clean the panel, unless the acid is tied up in the form of a cross-linking complex.

Alternatively, other methods of cross-linking are contemplated, for example, other multivalent valent metal cations may be used including calcium and magnesium. These cross-links improve coating durability by increasing the polymer molecular weight, and actually enhance the sensitivity of any remaining, uncross-linked acid to swelling as amine salts (thus improving film removability with amine-containing stripper formulations).

Optional monoethylenically unsaturated monomers that may be employed in amounts up to 50% of the total monomers in preparing the water-insoluble addition copolymer include those having the H₂C=C-group such as the monovinyl aromatic compounds styrene and vinyl toluene (o, m or p), as well as acrylonitrile, methacrylonitrile, vinyl acetate, vinyl chloride or vinylidene chloride. Such monomers may affect viscosity but do not ordinarily affect the gloss or the molecular weight, and they are thus not essential. Since the pH of the final formulation is alkaline and usually exceeds 7.5, potential hydrolysis of the vinyl ester units is minimized. The term "vinyl monomers" refers to monomers that contain a carbon-carbon double bond that is connected to a heteroatom such as nitrogen or oxygen. Examples of vinyl monomers include, but are not limited to, vinyl acetate, vinyl formamide, vinyl acetamide, vinyl pyrrolidone, vinyl caprolactam, and long chain vinyl alkanoates such as vinyl neodecanoate, and vinyl stearate.

The polyvalent metal compound, if employed in the coating formulation, may be either a metal complex or a metal chelate. The polyvalent metal ions may be those of beryllium, cadmium, copper, calcium, magnesium, zinc, zirconium, barium, strontium, aluminum, bismuth, antimony, lead, cobalt, iron, nickel or any other polyvalent metal which can be added to the composition by means of an oxide, hydroxide, or basic, acidic, or neutral salt which has appreciable solubility in water, such as at least about 1% by weight therein. The selection of polyvalent metal and the anion are governed by the solubility of the resultant metal complex in order to insure adequate clarity of the final formulated coating. Zinc, cadmium, zirconium, calcium and magnesium are particularly preferred polyvalent metal ions. The ammonia and amine complexes (and especially those coordinated with NH₃) of the zinc, cadmium and zirconium metals are particularly useful. Amines capable of so complexing include morpholine, monoethanol amine, diethylaminoethanol, and ethylenediamine. Polyvalent metal complexes (salts) of organic acids that are capable of solubilization in an alkaline pH range may also be employed. Such anions as acetate, glutamates, formate, carbonate, salicylate, glycollate, octoate, benzoate, gluconate, oxalate and lactate are satisfactory. Polyvalent metal chelates where in the ligand is a bidentate amino acid such as glycine or alanine may also be employed. The polyvalent metal compound must be such that the metal is available to serve its cross-linking function, i.e., it is dissociable to form polyvalent metal-containing ions.

Preferred polyvalent metal compounds, complexes and chelates include zinc acetate, zirconium ammonium carbonate, zirconium tetrabutanolate, sodium zirconium lactate, cadmium acetate, zinc glycinate, cadmium glycinate, zinc carbonate, cadmium carbonate, zinc benzoate, zinc salicylate, zinc glycollate and cadmium glycollate. Although the polyvalent metal compound may be added to the coating composition in dry form such as a powder, it is preferred to first solubilize the polyvalent metal compound using a fugitive ligand such as ammonia. For purposes of this invention a ligand is considered fugitive if at least a portion of said ligand tends to volatilize under normal film forming conditions. Since the ammonia may complex with the polyvalent metal compound, a compound such as zinc glycinate, when solubilized in dilute aqueous ammonia solution, may be named zinc ammine glycinate.

The polyvalent metal compound when used is employed in an amount so that the ratio of polyvalent metal to the polymer acid functionality of the addition polymer varies from about 0.05 to 0.5, and preferably from about 0.2 to 0.3. This is expressed as the ratio of metal, such as Zn++, to--COOH or--COONH4 groups, a ratio of 0.5 being stoichiometric.

In one embodiment, the restrippable coating is an aqueous coating composition having a pH of 7.0 to 9.6, comprising on a weight percent basis:
a) about 1 to 20% of an alkali soluble addition polymer comprising:
   i) from about 10 to 25% of recurring units of at least one hydrophilic monomer selected from the group consisting of (meth)acrylic acid, itaconic acid, and maleic acid:
   ii) from about 60 to 75% of at least one hydrophobic monomer selected from the group consisting of alkyl acrylate and alkyl methacrylate, wherein alkyl has from 1 to 8 carbon atoms; and
   iii) 15 to 25% of recurring units of at least one hydrophobic monomer selected from the group consisting of styrene and monoalkylstyrene wherein alkyl has from 1 to 6 carbon atoms;
b) about 1 to 13% of an alkali soluble copolymer of styrene and acrylic acid having a styrene-acrylic acid ratio of about 2:1 to about 3:1, a weight average molecular weight of about 8000 and an acid number of about 210;
c) about 1 to 15% of a fugitive solvent;
d) about 1 to 3% of a permanent plasticizer;
e) about 0.01 to 0.05% by weight of a nonionic or anionic fluorocarbon surfactant;
h) about 0.0003 to 0.003% by weight of an antifoaming agent; and
i) sufficient water to make a composition have a total content of non-volatile solids of from about 5 to 50% by weight.

Optionally, further comprising a 0.5-20µm spherical antireflective particle or other anti-reflective composition

Optionally, a silane coupling agent or other adhesion promoter.

In another embodiment, the restrippable coating is an aqueous coating composition having a pH of 7.0 to 9.6, comprising on a weight percent basis:
a) about 0 to 70% by dry weight of a 0.5-20µm spherical polymer particle relative to a film forming polymer;
b) about 0-5% of a hydrophobic rheology modifier;
c) about 0-5% of an alkali soluble thickener;
d) if a) is present, then about 0.1-0.8% of a clay thickener (such as bentonite or Laponi te);
e) about 0-40% of a coalescing solvent;
f) about 0-2.5% of a silane coupling agent; and
g) sufficient water to make a composition have a total content of non-volatile solids of from about 5 to 50% by weight.

When coated on panels the compositions of the invention provide slightly opaque/diffuse coatings. Upon application to a substrate it dries within 20-30 minutes, under normal humidity and temperature conditions, to a thin, protective film which preserves the appearance of the substrate. Substrates coated with the compositions provide excellent protection against soiling and greatly improved antireflective properties (when containing antireflective materials). The compositions clean and restore the antireflective properties of the solar panel simultaneously and the coating is easily removable with common ammonia/amine cleaning solutions. The compositions have good storage stability under temperature and humidity conditions normally encountered during storage. Preferably, the film comprising the present invention is produced by coating an aqueous emulsion of the present invention onto the exterior sun-facing layer of a photovoltaic module and allowing the coating to dry. Preferably, the wet coating has a thickness from 10 to 250 µm, preferably from 20 to 150 µm, preferably from 40 to 100 µm.

Another example is a self-stripping aqueous coating composition for application to the surface of photovoltaic modules, designed to concurrently disperse a previously deposited dried coating composition and replace the dried composition with a new coat, includes a solution of a an alkali soluble polymer of low molecular weight (between 5,000 - 100,000) and high acid number (100 - 230) and aqueous ammonia (or amine) in sufficient concentration to provide a pH greater than 7.0 and less than about 9.5. The acid number is expressed in milligrams of potassium hydroxide per gram of polymer: acid number (mg KOH/gram polymer) = (V x N x 56.1)/P where V = milliliters of potassium hydroxide solution required for polymer titration, N = normality of potassium hydroxide solution, and P = grams of polymer used. Solvents, leveling agents, plasticizers, surfactants, defoamers and aqueous dispersions of waxes may be employed in the coating composition as well as conventional additives, as well as optionally antireflective composition. Additionally, metal-ligand complexes can be used as needed in the compositions that provide self-stripping properties. Such compositions are applied onto the exterior sun-facing layer of a photovoltaic module and allowed to dry.

In yet another example, the restrippable coating comprises a polyurethane dispersion having a slope of the stress modulus versus temperature curve from about -5 to 30N×cm²(°C) (-0.50x10⁶ to about -3.00x10⁶ dynes per (cm²))(°C). Particularly preferred dispersions are those of polyurethane described in US 2008/0096995 (US Application Serial Number 11/665,119). These natural oil polyol based polyurethanes have a number of benefits, including sustainability, since the isocyanate-reactive material includes at least one hydroxymethyl-containing polyester polyol which is derived from a fatty acid. The fatty acids employed may come from a number of fats, such as canola oil, citrus seed oil, cocoa butter, corn oil, cottonseed oil, linseed oil, olive oil, palm oil, peanut oil, rapeseed oil, rice bran oil, safflower oil, sesame oil, soybean oil, sunflower oil, lard, chicken fat, or beef tallow. Without being bound by theory, the unique functionality that the polyurethane dispersions provide is believed attributable to a optimal range of crosslinking being present within the polyurethane dispersions, where durability is provided when a film is formed from them, but not so much durability as to prevent the swelling forces generated by the interaction of the polymeric functionality with a stripper solution from disrupting the film integrity and being readily removed. It is understood that the spirit of the invention encompasses adjusting the amount of cross-linking. For example, increased crosslinking can increase the tensile strength of the dried coating composition, promoting durability and detergent resistance. On the other hand, reducing cross-linking can increase removability. Accordingly, a balance may be struck for a particular application. As posited above, a productive range of cross-linking correlates to the removability of the coating. In one embodiment, the preferred range of slopes of the stress modulus versus temperature curve for polyurethane dispersions useful in the present invention is from about -0.50x10⁶ to about -30N×cm²(°C)(3.00x10⁶ dynes per (cm²)(°C)), more preferably about -10 to about -27.5, more preferably about -15 to about -25, more preferably about -16.5 to about -24, and most preferably about -18 to about -23 N×cm²(°C), (-1.00x10⁶ to about -2.75x10⁶, more preferably about -1.50x10⁶ to about -2.50x10⁶, more preferably about -1.65x10⁶ to about -2.40x10⁶, and most preferably about -1.80x10⁶ to about -2.30x10⁶). In one embodiment, a preferred removeable polyurethane dispersion is a 34.6% polymer solids polyurethane dispersion with a pH of 9.2, being zinc free and alkyl phenol ethoxylate ("APEO") surfactant free. Another preferred removeable polyurethane dispersion is a 35.9% polymer solids polyurethane dispersion with a pH of 9.4, being zinc free and APEO surfactant free. The restrippable coating is applied onto the exterior sun-facing layer of a photovoltaic module and allowed to dry.

### Examples

The following examples are for illustrative purposes only and are not intended to limit the scope of the present invention.

### Example 1: Film forming Polymer

**TABLE 1**

| **Mixture** | **Component** | **Parts by Weight** |
|---|---|---|
| A | Water | 234 |
| | 28% aqueous sodium lauryl sulfate | 30 |
| | 23% aqueous sodium dodecylbenzenesulfonate | 30 |
| | BA | 723.7 |
| | AA | 26.3 |
| B | 0.15% ferrous sulfate heptahydrate | 4.0 |
| C | Water | 35 |
| | Ammonium persulfate | 0.8 |
| D | Water | 25 |
| | Sodium hydrosulfite | 1.4 |
| | Ammonium hydroxide | 0.4 |
| E | Water | 10 |
| | t-Butyl hydroperoxide | 0.45 |
| F | Water | 10 |
| | Sodium formaldehyde sulfoxylate | 0.35 |
| G | Methyl methacrylate | 250 |
| H | Water | 9 |
| | t-Butyl hydroperoxide | 0.9 |
| I | Water | 38 |
| | Sodium formaldehyde sulfoxylate | 0.7 |
| J | Water | 35 |
| | t-Butyl hydroperoxide | 1.5 |
| K | Water | 35 |
| | Sodium formaldehyde sulfoxylate | 1.5 |
| L | Neutralizer (triethyl amine to pH 7-8) | |

A reactor equipped with a stirrer and condenser was charged with 1035 g of deionized water. Nitrogen was allowed to bubble through the water for 30 minutes. The reactor was then blanketed with nitrogen and charged with Mixture A. With the reactor mixture temperature below 20°C, Mixtures B, C and D were rapidly and successively added to the reactor. Within 10 minutes, the temperature rose as the polymerization started and peaked around 70°C. Ten minutes after the peak temperature, mixture E followed by mixture F were added. The material in the reactor was allowed to cool to 60°C and Mixture G was added followed by Mixtures H and I. After 5 minutes, mixtures J and K were separately metered into the reactor over 30 minutes while the batch was cooled. The neutralizer was then added to partially neutralize the polymerized acid and the polymer sample was then filtered through a 100 mesh screen to remove coagulum.

The primary glass transition temperature of this polymer was measured to be -41.3°C using differential scanning calorimitry at a heating rate of 10°C/min.

### Example 2: Film Forming polymer

The following mixtures were prepared according to procedure from example 1:

**TABLE 2**

| **Mixture** | **Component** | **Parts by Weight** |
|---|---|---|
| A5 | Water | 238.58 |
| | 28% aqueous sodium lauryl sulfate | 28.99 |
| | 30% aqueous secondary alcohol ethoxylate (15.4 HLB) | 108.21 |
| | Ethyl Acrylate | 783.18 |
| | Acrylic Acid | 28.41 |
| B5 | 0.15% ferrous sulfate heptahydrate | 4.08 |
| C5 | Water | 25.49 |
| | Ammonium persulfate | 0.81 |
| D5 | Water | 25.49 |
| | Sodium hydrosulfite | 1.43 |
| | Ammonium hydroxide | 0.41 |
| E5 | Water | 20 |
| | t-Butyl hydroperoxide | 0.46 |
| F5 | Water | 20 |
| | Disodium salts of 2-hydroxy-2- sufinatoacetic acid and 2-hydroxy-sufonatoacetic acid, sodium sufite. | 0.47 |
| G5 | Methyl methacrylate | 202.90 |
| H5 | Water | 9.18 |
| | t-Butyl hydroperoxide | 0.92 |
| 15 | Water | 38.74 |
| | Disodium salts of 2-hydroxy-2- sufinatoacetic acid and 2-hydroxy-sufonatoacetic acid, sodium sufite. | 0.9 |
| J5 | Water | 35.69 |
| | t-Butyl hydroperoxide | 1.53 |
| K5 | Water | 35.69 |
| | Disodium salts of 2-hydroxy-2-sufinatoacetic acid and 2-hydroxy-sufonatoacetic acid, sodium sufite. | 1.33 |
| L5 | Triethylamine | 17.84 |
| | Water | 50.98 |

### Example 3: Synthesis of Emulsion Polymer Seed

### Preparation Example 3A

This example illustrates preparation of an emulsion polymer for use in preparing the core/shell particles which are the preferred antireflective compositions of the present invention. Unless otherwise noted, the terms "charged" or "added" indicate addition of all the mixture at once. The following mixtures were prepared:

**TABLE 3**

| **Mixture** | **Component** | **Parts By Weight** |
|---|---|---|
| A | Water | 208 |
| | Sodium Carbonate | 0.38 |
| B | BA | 98 |
| | Butylene Glycol Diacrylate | 0.25 |
| | ALMA | 2.0 |
| | 10% aqueous Sodium Dodecylbenzenesulfonate | 4.0 |
| | Water | 40 |
| C | Potassium Persulfate | 0.063 |
| | Water | 35 |

A reactor equipped with stirrer and condenser and blanketed with nitrogen was charged with Mixture A and heated to 82°C. To the reactor contents was added 15% of Mixture B and 25% of Mixture C. The temperature was maintained at 82°C. and the reaction mixture was stirred for 1 hour, after which the remaining Mixture B and Mixture C were metered in to the reactor, with stirring, over a period of 90 minutes. Stirring was continued at 82 °C for 2 hours, after which the reactor contents were cooled to room temperature. The average diameter of the resulting emulsion particles was 0.2 µm, as measured by light scattering using a BI-90 Plus instrument from Brookhaven Instruments Company, 750 Blue Point Road, Holtsville, NY 11742.

### Preparation Example 3B:

**TABLE 4**

| **Mixture** | **Component** | **Parts by Weight** |
|---|---|---|
| A2 | Sodium Carbonate | 0.08 |
| | 50% Methoxy-beta-cyclodextrin | 2.0 |
| | Water | 153.3 |
| B2 | Aqueous emulsion from Example 3A | 8.41 |
| C2 | *n*-Butyl Acrylate | 82.0 |
| | Methyl Methacrylate | 17.8 |
| | Methacrylic Acid | 0.20 |
| | 9.76% aqueous Sodium Dodecylbenzenesulfonate | 4.18 |
| | Water | 22.21 |
| D2 | *n*-Dodecyl Mercaptan | 22.00 |
| | 9.76% aqueous Sodium Dodecylbenzenesulfonate | 2.04 |
| | Water | 21.65 |
| E2 | Sodium Persulfate | 0.20 |
| | Water | 10.0 |
| F2 | *t*-Butyl Hydroperoxide 70% | 0.30 |
| | Water | 15.00 |
| G2 | Sodium Formaldehyde Sulfoxylate | 0.20 |
| | Water | 6.67 |

Mixture A2 was added to the reactor and heated to 88°C with stirring. The air in the reactor was replaced by nitrogen. When the reactor temperature stabilized at 88°C, Mixture B2 was charged into the reactor. Emulsified Mixtures C2 and D2, and Mixture E2 were then added to the reactor, with stirring, over a period of 240 minutes. Stirring was continued at 88°C for 90 minutes. The reactor contents were cooled to 65°C. Mixtures F2 and G2 were added and the reactor contents were maintained at 65°C with stirring for 1 hour, after which the reactor contents were cooled to room temperature. The resulting emulsion particles had a diameter of 0.75 µm as measured by a Brookhaven Instruments particle size analyzer BI-90.

### Example 4: 5 µm Gradient Refractive index particle

In this example, the particles in the emulsion of Example 3B are expanded to create 5 µm diameter divergent lenses using *n*-butyl acrylate and allyl methacrylate in Stage I which is then followed by Stage II copolymerization of methyl methacrylate and ethyl acrylate. The following mixtures A3-G3 were prepared with deionized water:

**TABLE 5**

| | | |
|---|---|---|
| **Mixture** | **Component** | **Parts by Weight** |

| Stage I | | |
|---|---|---|
| A4 | Water | 1400.0 |
| B4 | Aqueous emulsion from Example 3B | 9.70 |
| C4 | *n*-Butyl Acrylate | 768.0 |
| | Allyl Methacrylate | 32.0 |
| | 23% aqueous Sodium Dodecylbenzenesulfonate | 12.60 |
| | Water | 324.4 |
| D4 | *t*-Butyl Peroctoate | 3.82 |
| | 23% aqueous Sodium Dodecylbenzenesulfonate | 0.16 |
| | Water | 8.40 |

| Stage II | | |
|---|---|---|
| E4 | Methyl Methacrylate | 191.7 |
| | Ethyl Acrylate | 8.30 |
| | 23% aqueous Sodium Dodecylbenzenesulfonate | 2.43 |
| | Water | 50.2 |
| F4 | 2% Sodium Formaldehyde Sulfoxylate in water | 40.0 |
| G4 | *4*.*4*% *t*-Butyl Hydroperoxide (70%) in water | 24.90 |

To a reactor A4 was added and was heated to 76°C with stirring. The air in the reactor was replaced by nitrogen. When the reactor temperature stabilized at 76°C, Mixture B4 was charged into the reactor. Mixture C4 was emulsified with a homogenizer and 20% was charged into the reactor. The reactor was stirred at 60-65°C for 0.5 hours. Mixture D4 was emulsified with a homogenizer and charged into the reactor. After 23 minutes agitation at 60-65°C an exothermic polymerization took place. After reaching peak temperature, agitation was continued while the remaining 80% of mixture C4 was added over 48minutes. 27.5% of Mixture F4 was charged. Mixtures E4, the remainder of F4, and G4 were then separately added into the reactor over a period of 45 minutes. The temperature was maintained between 75-80°C and stirring was continued for 1 hour before the reactor was cooled to room temperature. To the resultant polymer 1.5% of thickener B is added based on the total weight of the emulsion and the pH is increased by sequential additions of triethylamine until a pH of 7-9 is achieved.

### Example 5: Formulation of PV ARC coating

Thickener A: Acrysol™ RM-825

The following formulations were prepared for determination of improving solar cell efficiency

**TABLE 6**

| **Formulation** | **Binder** | **Binder grams** | **Antireflective Particle grams** | **Water grams** | **Thickener A grams** | **Total grams** |
|---|---|---|---|---|---|---|
| 5A | Ex. 1 | 155 | 0 | 40.6 | 4.4 | 200 |
| 5B | Ex. 1 | 109 | 53 | 34 | 5 | 201 |
| 5C | Ex. 1 | 62 | 105 | 28 | 5 | 200 |
| 5D | Ex. 2 | 160 | 0 | 35 | 5 | 200 |
| 5E | Ex. 2 | 112 | 52.5 | 30.5 | 5 | 200 |
| 5F | Ex. 2 | 64 | 105 | 26.5 | 4.5 | 200 |

| | | | | | | |
|---|---|---|---|---|---|---|
| Antireflective particle was from Example 4. | | | | | | |

### Example 6: Formulation of PV ARC coating containing coupling Agent

Coupling Agent A: N(beta-aminoethyl)gamma-aminopropyltrimethoxy-silane
Thickener B: Acrysol™ ASE-60

**TABLE 7**

| **Formulation** | **Binder grams** | **Antirefle ctive Particle grams** | **Water grams** | **Coupling Agent A grams** | **Thickener grams** | **Aq. NH₃ (28%)** | **Total grams** |
|---|---|---|---|---|---|---|---|
| 6A | 160 | 0 | 35.0 | 0.65 | A 5.0 | | 200.65 |
| 6B | 112 | 30.5 | 30.5 | 0.65 | A 5.0 | | 200.65 |
| 6C | 64 | 105 | 26.5 | 0.65 | A 4.5 | | 200.65 |
| 6D | 112 | 52.5 | 32.5 | 0 | B 3.0 | 0.6 | 200.60 |
| 6E | 112 | 52.5 | 32.5 | 0.65 | B 3.0 | 0.6 | 201.25 |
| 6F | 64 | 105 | 28 | 0 | B 3.0 | 0.8 | 200.80 |
| 6G | 64 | 105 | 28 | 0.65 | B 3.0 | 0.8 | 201.45 |

| | | | | | | | |
|---|---|---|---|---|---|---|---|
| Binder from Example 2 in all formulations. Antireflective particle was from Example 4. | | | | | | | |

### Example 7: Film forming polymer

The emulsion polymerized polymer was made of (parts by weight): 29% BA/52% MMA/19% MAA and prepared as described in US 3,037,952 employing sufficient chain transfer agent (3-mercapto-propionic acid) to provide a Mw of about 30,000 as measured by Gel Permeation Chromatography. The final pH of the emulsion was between 5.0 - 6.0 and the final total solids of the emulsion were about 38%. The Tg of the composition was determined to be 85°C using Differential Scanning Calorimetry. The pH of this polymer was adjusted to 8-9 with diluted ammonium hydroxide prior to formulating.

### Example 8: Film forming polymer

The emulsion polymerized polymer was made of (parts by weight): 28% BA/62% MMA/10% MAA and 0.69% Zn based on total weight of emulsion was prepared as described in US 4,517,330 except that potassium hydroxide was not employed as part of the composition. The final pH of the emulsion was about 7.6 - 8.3 and the final total solids of the emulsion were about 38%. The Tg of the composition was determined to be 87°C using Differential Scanning Calorimetry. The Mw of the composition prior to the addition of Zn was determined to be about 338,000 as measured by Gel Permeation Chromatography and greater than 3,000,000 after the Zn was added to the composition.

### Example 9: Formulation of PV ARC coating

**TABLE 8**

| **Formulation** | **Binder grams** | **Antirefle ctive Particle grams** | **Water grams** | **tributoxyethyl phosphate/ Dibutyl Phthlate** | **Solvent mixture grams** | **Thickener grams** | **Total Grams** |
|---|---|---|---|---|---|---|---|
| 9a | 160 | 0 | 18.6 | | 17 | A7 | 202.6 |
| 9b | 112 | 52.5 | 13.5 | | 17 | A5 | 200 |
| 9c | 64 | 105 | 9 | | 17 | A5 5 | 200 |
| 9d | 160 | 0 | 18.6 | 2/2 | 17 | A7 | 206.6 |
| 9e | 112 | 52.5 | 13.5 | 2/2 | 17 | A5 | 204 |
| 9f | 64 | 105 | 9 | 2/2 | 17 | A5 | 202 |

| | | | | | | | |
|---|---|---|---|---|---|---|---|
| Binder from Example 7 in all formulations. Antireflective particle was from Example 4. Solvent mixture was: 8g Diethylene glycol monoethyl ether+12 g Dipropylene Glycol Methyl Ether | | | | | | | |

### Example 10: Formulation of PV ARC coating

**TABLE 9**

| **Formulation** | **Binder grams** | **Antirefle ctive Particle grams** | **Water grams** | **tributoxyethyl phosphate/ Dibutyl Phthlate** | **Solvent mixture grams** | **Thickener grams** | **Total Grams** |
|---|---|---|---|---|---|---|---|
| 10a | 103 | 52.5 | 23.8 | | 17 | A 3.7 | 200 |
| 10B | 59 | 105 | 15.2 | | 17 | A 3.8 | 200 |
| 10C | 147 | 0 | 29 | 2/2 | 17 | A 7 | 204 |
| 10D | 103 | 52.5 | 22.5 | 2/2 | 17 | A5 | 204 |
| 10E | 59 | 105 | 14.0 | 2/2 | 17 | A5 | 204 |

| | | | | | | | |
|---|---|---|---|---|---|---|---|
| Binder from Example 8 in all formulations. Antireflective particle was from Example 4. Solvent mixture was: 8g Diethylene glycol monoethyl ether+12 g Dipropylene Glycol Methyl Ether | | | | | | | |

Into a plastic paint container (250ml volume capacity) the materials described in examples 5,6,9 and 10 were added and stirred until completely homogenized using a mechanical lab top mixer. After completely homogenized, the formulations were applied to glass plates (6"x6" SolarPhire™ brand from PPG, 3.2mm thick) using a #38 wire round rod. The coatings were allowed to dry for a minimum of 2 days at ambient conditions. After completely dry, the coatings applied to the solar glass were assessed for surface gloss (using a spectral gloss meter, Micro-tri-gloss catalogue # 4520 BYK Gardner company), reflectance (using a Sphere spectrometer, X-Rite 8400 and X-Rite Color Master Software version 5.1.1, X-Rite incorporated) and relative solar spectrum transmission (using a single crystal silicon solar cell and a Solar Cell Simulator (QuickSun™120CA, Endeas OY). To measure the gloss of the coating, the glass plate was layed against a Penopec 1B black/white chart and the measurement for 20, 60 and 85 degree spectral gloss was made against the black portion of the chart. To measure reflectance, the coated side of the glass plate was placed against the integrating sphere portion of the spectrometer and a black background was placed against the un-coated side of the plate. The measurement was made using the spectral reflectance included setting and the reflectance at 550nm was recorded. For solar power determinations, immersion fluid (Refractive index 1.5215, code 5040 Cargille laboratories) was applied to the single crystal silicon PV cell (78.5cm² circle shaped cell) and the uncoated side of the glass was placed onto the immersion fluid (so that all air gaps were removed), each sample plate was measured 2 time in different locations to determine the short circuit current (Jsc). An uncoated plate was used as the blank substrate and the calculation for % efficiency increase was as follows: ((Jsc coated plate-Jsc of uncoated plate)/Jsc of uncoated plate)*100

**TABLE 10**

| **Formulation** | **Gloss** | | | | **Efficiency % increase** | |
|---|---|---|---|---|---|---|
| | | | | **Reflectance** | **Measure** | **Replicate** |
| | **20°** | **60°** | **85°** | **550nm** | | |
| 5A | 182 | 159.7 | 116.5 | 11.64 | 0.837 | 0.738 |
| 5B | 3.4 | 12.8 | 15.4 | 11.545 | 0.394 | 0.492 |
| 5C | 0.9 | 10.1 | 7.6 | 10.568 | 1.919 | 1.673 |
| 5D | 174 | 155.1 | 114.2 | 11.678 | 0.64 | 0.689 |
| 5E | 4.7 | 14.9 | 17.4 | 11.592 | 0.591 | 0.541 |
| 5F | 0.9 | 9.6 | 8.1 | 10.484 | 2.165 | 2.165 |
| 6A | 180 | 159.7 | 118.3 | 11.548 | 0.591 | 0.492 |
| 6B | 3.6 | 14.1 | 17 | 11.459 | 0.689 | 0.738 |
| 6C | 1.0 | 11.8 | 9.0 | 10.412 | 2.116 | 2.067 |
| 6D | 2.4 | 12.4 | 10.9 | 11.309 | 0.787 | 0.935 |
| 6E | 2.4 | 11.9 | 10.3 | 11.226 | 0.886 | 0.935 |
| 6F | 0.8 | 10.2 | 6.6 | 9.908 | 2.805 | 2.805 |
| 6G | 0.8 | 8.8 | 6 | 9.420 | 3.642 | 3.740 |
| 9a | 175 | 156.1 | 115.5 | 11.78 | 0.837 | 0.541 |
| 9b | 42.6 | 56.1 | 75.7 | 11.865 | 0.492 | 0.295 |
| 9c | 4.9 | 14.4 | 31.9 | 11.726 | 0.935 | 0.492 |
| 9d | | 162.5 | 119.2 | 11.851 | 0.787 | 0.64 |
| 9e | 26.2 | 38.4 | 69.5 | 11.777 | 0.541 | 0.64 |
| 9f | 2.8 | 11.8 | 18.3 | 11.743 | 0.837 | 0.689 |
| 10A | 9.0 | 21.6 | 31.7 | 11.736 | 0.738 | 0.64 |
| 10B | 1.9 | 11.1 | 21.1 | 11.579 | 0.886 | 0.738 |
| 10C | 0 | 163.3 | 121.6 | 11.865 | 0.935 | 0.837 |
| 10D | 5.9 | 17.7 | 22.7 | 11.744 | 0.591 | 0.443 |
| 10E | 1.5 | 10.8 | 11.7 | 11.356 | 1.132 | 1.033 |

| | | | | | | |
|---|---|---|---|---|---|---|
| (note: Isc for uncoated glass was 2.032, an average of 8 replicate measurements) | | | | | | |

The test for removability was performed 2 days after the coatings were applied to the glass substrates. For these tests the coated glass substrates were stored in an oven set at 42°F from when the coatings were applied to the substrate until right before the test was performed.

The method for determining coating removability utilized a commercial floor stripping solution along with an Abrasion Tester apparatus (Model No. AG-8100 from Pacific Scientific, Gardner/Neotec Instrument Division, Silver Spring, Maryland, USA, equipped with a PB-8112 nylon brush from Byk Additives & Instruments, Columbia, Maryland, USA) as a means of reproducibly determining the removal of the dried films. In order to distinguish between the relative removal properties of different coatings, the number of cycles for the brush to move back and forth over the coated surface to effect complete removal of the film was taken as a measure of removability. The commercial floor stripper used was FREEDOM@ (Diversey Inc. Sturtevant, Wis. 53177 USA) which contained multiple reagents to swell the polymer film including: solvents, such as diethylene glycol phenyl ether, and ethylene glycol phenyl ether, amines such as monoethanolamine, and surfactants such as sodium xylene sulfonate. The commercial floor stripper was diluted with clean tap water generating a dilution solution of 1 part FREEDOM® stripper and 4 parts clean tap water. The coated glass substrate was placed on the Abrasion Tester apparatus in such a manner that the brush traveled at right angles to the longer side of the dried film. 5mL. of diluted stripper solution was placed on the panel and then the Abrasion Tester machine was activated to allow the brush to oscillate back and forth over the panel. The following rating system was used: Number of Cycles Required for Total Removal: <10 (Excellent Ease of Removal), > 10 but < 20 (Good), > 20 but < 50 (Fair), > 50 (Poor).

**TABLE 11**

| **Example** | **Number of Cycles Required for Total Removal** |
|---|---|
| 6E | 8 |
| 6G | 4 |
| 9d | 4 |
| 9e | 5 |
| 9f | 3 |
| 10C | 25-50 |
| 10D | 17 |
| 10E | 8 |

It is understood that the present invention is not limited to the embodiments specifically disclosed and exemplified herein.

## Claims

1. A method for protecting a photovoltaic module, comprising applying a restrippable coating to the exterior sun-facing layer of the photovoltaic module, allowing the photovoltaic module to operate, removing the coating from the photovoltaic module, and reapplying the coating to the photovoltaic module,
wherein the restrippable coating is a clear aqueous acrylic composition, containing a highly hydrophilic addition copolymer, a water miscible organic coalescing agent or plasticizer and, as optional components, a polyvalent metal compound, a rheology modifier, an alkali-soluble resin and a wax, with or without a wax-soluble resin, and optionally a silane coupling agent.

2. The method of claim 1, wherein the coating that is applied and reapplied is generated from an aqueous coating composition having a pH of 7.0 to 9.6.

3. The method of claim 2, wherein the aqueous coating composition has a total content of non-volatile solids of from 5 to 50% by weight.

4. The method of claim 1, wherein the coating is (meth)acrylate based.

5. The method of claim 1, wherein the coating is a polyurethane dispersion having a slope of the stress modulus versus temperature curve from -0.5x10⁶ to - 3.00x10⁶ dynes per (cm²)(°C).

6. The method of claim 1, wherein the coating further comprises an anti-reflective composition.

7. The method of claim 1, wherein the coating, when dry, has a refractive index from 1.25 to 1.7.

8. The method of claim 1, wherein the acrylic compositions are based on moderately acid functionalized (meth)acrylate or styrene/methacrylate copolymer emulsions wherein the polymers have an average molecular weight Mw of from 5,000 to 10,000,000.

9. The method of claim 8, wherein the acid functionality may be crosslinked with multivalent metal cations.

10. The method of claim 9, wherein the multivalent metal cation is selected from the group consisting of zinc, cadmium, zirconium, calcium or magnesium.

## Patentansprüche

1. Ein Verfahren zum Schutz eines photovoltaischen Moduls, beinhaltend das Aufbringen einer wiederablösbaren Beschichtung auf eine äußere, der Sonne zugewandten Schicht des photovoltaischen Moduls, so dass das photovoltaische Modul betriebsfähig ist, das Entfernen der Beschichtung von dem photovoltaischen Modul und das erneute Aufbringen der Beschichtung auf das photovoltaische Modul,
wobei die wiederablösbare Beschichtung eine klare wässrige Acrylzusammensetzung ist, die ein stark hydrophiles Additionscopolymer, ein wassermischbares organisches Filmbildungshilfsmittel oder einen wassermischbaren organischen Weichmacher und, als optionale Komponenten, eine mehrwertige Metallverbindung, einen Rheologiemodifikator, ein alkalilösliches Harz und ein Wachs, mit oder ohne wachslöslichem Harz, und optional einen Silanhaftvermittler enthält.

2. Verfahren gemäß Anspruch 1, wobei die Beschichtung, die aufgebracht und erneut aufgebracht wird, aus einer wässrigen Beschichtungszusammensetzung mit einem pH-Wert von 7,0 bis 9,6 erzeugt wird.

3. Verfahren gemäß Anspruch 2, wobei die wässrige Beschichtungszusammensetzung einen Gesamtgehalt an nichtflüchtigen Feststoffen von 5 bis 50 Gew.-% aufweist.

4. Verfahren gemäß Anspruch 1, wobei die Beschichtung auf (Meth)acrylat basiert.

5. Verfahren gemäß Anspruch 1, wobei die Beschichtung eine Polyurethandispersion mit einer Steigung des Beanspruchungsmoduls zu der Temperaturkurve von -0,50 x 10⁶ bis -3,00 x 10⁶ dyn pro (cm²)(°C) aufweist.

6. Verfahren gemäß Anspruch 1, wobei die Beschichtung ferner eine antireflektierende Zusammensetzung beinhaltet.

7. Verfahren gemäß Anspruch 1, wobei die Beschichtung im trockenen Zustand einen Brechungsindex von 1,25 bis 1,7 aufweist.

8. Verfahren gemäß Anspruch 1, wobei die Acrylzusammensetzungen auf mäßig sauren funktionalisierten (Meth)acrylat- oder Styrol/Methacrylat-Copolymer-Emulsionen basieren, wobei die Polymere ein mittleres Molekulargewicht Mw von 5000 bis 10 000 000 aufweisen.

9. Verfahren gemäß Anspruch 8, wobei die Säurefunktionalität mit mehrwertigen Metallkationen quervernetzt werden kann.

10. Verfahren gemäß Anspruch 9, wobei das mehrwertige Metallkation aus der Gruppe, bestehend aus Zink, Cadmium, Zirkon, Calcium oder Magnesium, ausgewählt ist.

## Revendications

1. Une méthode pour protéger un module photovoltaïque, comprenant le fait d'appliquer un revêtement pelable plusieurs fois sur la couche faisant face au soleil extérieure du module photovoltaïque, de laisser fonctionner le module photovoltaïque, de retirer le revêtement du module photovoltaïque, et de réappliquer le revêtement sur le module photovoltaïque,
dans laquelle le revêtement pelable plusieurs fois est une composition acrylique aqueuse limpide, contenant un copolymère d'addition hautement hydrophile, un plastifiant ou agent de coalescence organique miscible à l'eau et, comme constituants facultatifs, un composé de métal polyvalent, un modificateur de rhéologie, une résine soluble dans les alcalis et une cire, avec ou sans résine soluble dans de la cire, et facultativement un agent de couplage silane.

2. La méthode de la revendication 1, dans laquelle le revêtement qui est appliqué et réappliqué est généré à partir d'une composition de revêtement aqueuse ayant un pH de 7,0 à 9,6.

3. La méthode de la revendication 2, dans laquelle la composition de revêtement aqueuse a une teneur totale en solides non volatiles allant de 5 à 50 % en poids.

4. La méthode de la revendication 1, dans laquelle le revêtement est à base de (méth)acrylate.

5. La méthode de la revendication 1, dans laquelle le revêtement est une dispersion de polyuréthane ayant une pente de la courbe du module de contrainte en fonction de la température allant de -0,50 x 10⁶ à -3,00 x 10⁶ dynes par (cm²)(°C).

6. La méthode de la revendication 1, dans laquelle le revêtement comprend en sus une composition anti-réfléchissante.

7. La méthode de la revendication 1, dans laquelle le revêtement a, lorsqu'il est sec, un indice de réfraction allant de 1,25 à 1,7.

8. La méthode de la revendication 1, dans laquelle les compositions acryliques sont à base d'émulsions de (méth)acrylate ou de copolymère styrène/méthacrylate à fonctionnalisation acide modérée dans lesquelles les polymères ont une masse moléculaire moyenne Mw allant de 5 000 à 10 000 000.

9. La méthode de la revendication 8, dans laquelle la fonctionnalité acide peut être réticulée avec des cations métalliques multivalents.

10. La méthode de la revendication 9, dans laquelle le cation métallique multivalent est sélectionné dans le groupe constitué de zinc, cadmium, zirconium, calcium ou magnésium.
